# EUROPÄISCHE PATENTSCHRIFT

(11) **EP 1 462 771 B1**
(45) Veröffentlichungstag und Bekanntmachung des Hinweises auf die Patenterteilung: **02.05.2007**
(21) Anmeldenummer: 04004882.9
(22) Anmeldetag: 02.03.2004
(51) Int. Cl.: G01D 5/14, G01D 5/245, G01D 5/249, G01P 13/04

(54) **Verfahren zur Messung und Bestimmung der absoluten Position einer Geberwelle sowie eine Einrichtung zur Anwendung des Verfahrens**
Method and apparatus for determining the absolute position of an encoder's shaft
Procédé et appareil pour déterminer la position absolue d'un axe d'un détecteur de position

(30) Priorität: 13.03.2003 DE 10311412
(43) Veröffentlichungstag der Anmeldung: 29.09.2004
(73) Patentinhaber: Lenord, Bauer & Co. GmbH, 46145 Oberhausen (DE)
(72) Erfinder: Höller, Heinrich, 47055 Duisburg (DE)
(74) Vertreter: Menges, Rolf

(56) Entgegenhaltungen:
- EP-A- 0 158 781
- EP-A- 0 331 828
- EP-A- 1 116 954
- DE-A1- 19 709 087
- DE-C1- 10 111 399

## Beschreibung

Die Erfindung betrifft ein Verfahren zur Messung und Bestimmung der absoluten Position einer Geberwelle durch eine Auswerteeinheit zur Erfassung und Auswertung der Position und der Anzahl der vollständig durchlaufenden Umdrehungen, mit einem drehfest gehaltenen ersten Sensorteil und einem an der Geberwelle angeordneten, mit diesem rotierenden, zweiten Sensorteil, wobei zumindest ein Sensorteil von einer Energiequelle versorgt wird und wobei die Sensorteile nur periodisch für die Zeit der Messung mit Strom/Spannung beaufschlagt werden.

Das Verfahren sowie die Einrichtung zur Anwendung des Verfahrens werden beispielsweise bei Servoantrieben mit Wechselstrommotoren eingesetzt, die in der Lage sind, eine Drehzahl in beiden Richtungen zu fahren und auf einen bestimmten Drehwinkel zu positionieren. Zum Einsatz kommen synchrone sowie asynchrone Motoren, wobei bei beiden Motorarten für den Einsatz als Servomotor sowohl die Information über die Drehzahl als auch die Information über den Drehwinkel zur Steuerung des Motors ermittelt werden muss. Hierzu sind aus dem Stand der Technik Verfahren und Einrichtungen bekannt, die jedoch nicht bei jedem Einsatzzweck zufriedenstellend arbeiten.

Im einfachsten Fall wird in kodierter Form eine digitale Spur auf einem Rotor zur Ermittlung der Winkelposition optisch abgetastet und die daraus abgeleitete Position kann jederzeit in digital kodierter Form zur Verfügung gestellt werden. Es hat sich jedoch heraus gestellt, dass derartige Verfahren und Schaltungseinrichtungen aufwändig und sehr träge sind.

Eine Verbesserung wurde mit einem inkrementalen Drehwinkelmesssystem erzielt, bei dem der Rotor eine Inkrementalspur mit einer Maßverkörperung in einer gewünschten Winkelauflösung aufweist. Die Inkrementalspur wird vorzugsweise optisch abgetastet, sodass die Winkelgeschwindigkeit der Informationen ermittelt werden kann und durch Zählen der digitalen Inkremente die jeweils absolute Winkelposition ermittelt wird. Beispielsweise ist aus der DE 34 20 600 A1 bekannt, die Abtastung der Inkrementalspur durch den Aufnehmer so zu gestalten, dass sich analoge annähernd sinusförmige elektrische Signale mit einer der Teilung der Inkrementalspur entsprechenden Periode ergeben. Durch eine Interpolation des Spannungssignals kann hierbei eine wesentliche Verbesserung der Auflösung erzielt werden. Vorzugsweise wird die Inkrementalspur hierbei durch den Aufnehmer in der Weise abgetastet, dass zwei in der Phase gegeneinander versetzte elektrische Signale erhalten werden, welche vorzugsweise um jeweils 90° versetzt sind, sodass ein Sinus- und ein Kosinussignal ermittelt wird. Hierdurch ist beispielsweise auch die Drehrichtung der Welle bestimmbar. Als nachteilig hat sich jedoch herausgestellt, dass bei inkrementalen Drehwinkelmesssystemen zur Bestimmung der absoluten Winkelposition eine Referenzmarkierung für den Nullpunkt der Zählung der Inkremente vorhanden sein muss. Dies ist besonders nachteilig, da beim Start stets zunächst die Referenzmarkierung angefahren werden muss, wodurch eine erhebliche Zeitverzögerung eintritt. Um diese Zeitverzögerung möglichst klein zu halten ist aus der DE 37 37 278 C2 bei einem Drehwinkelmesssystem die Verwendung einer Spur mit einer Vielzahl von Referenzmarkierungen bekannt. Der mögliche Mindestabstand der Referenzmarkierung und damit der notwendige Anfahrweg bei Betriebsbeginn ist durch die Winkelgenauigkeit der sinusförmigen Signale vorgegeben.

Aus der DE 42 20 502 C1 ist darüber hinaus bekannt, einen Rotor mit mehreren Spuren zu verwenden, die jeweils abgetastet werden, um sinusförmige oder annähernd sinusförmige elektrische Signale zu erhalten. Eine Abtastung kann je nach Art der Maßverkörperung auf den Rotor optisch, magnetisch oder in sonstiger an sich bekannter Weise erfolgen. Mit der Anzahl der Spuren steigt auch die Anzahl der Abtastsensoren, sodass der Stromverbrauch derartiger Drehwinkelmesssysteme in der Regel recht hoch ist und zur Lieferung der benötigten Energie eine individuelle Stromversorgung benötigt wird.

Aus der WO 99/57522 A1 ist ferner ein Multiturn-Codedrehgeber bekannt, der zur Erfassung der Umdrehungen einer Eingangswelle untersetzt angetrieben wird, wobei die Codeträger jeweils nur einen Nord- und Südpol aufweisen und jeder Codeträger von Magnetfeld empfindlichen Sensorelementen abgetastet wird. Im praktischen Einsatz hat sich jedoch gezeigt, dass die Genauigkeit dieser Multiturn-Codedrehgeber im höchsten Maße von dem Verschleiß und der Genauigkeit des Getriebes abhängig ist und im Einzelfall nach einem Verschleiß des Getriebes nicht tolerierbare Abweichungen entstehen. Darüber hinaus werden eine Vielzahl von Sensoren benötigt, die den Energieverbrauch ansteigen lassen.

Aus der EP 0 550 794 A1 ist ferner zur Reduzierung der notwendigen Größe der Versorgungsbatterie oder des Akkumulators und zur Pufferung des Drehgebers bei Ausfall der externen Stromversorgung eine Schaltung bekannt, die einen wenigstens bei geschlossenem Kontakt- bzw. Schaltelement sehr hochohmigen Widerstand in Reihe mit diesem aufweist, sodass der Strom in dieser Schaltung begrenzt wird. Im Übrigen wird die gesamte Logikschaltung hochohmig ausgelegt, um einen möglichst niedrigen Stromverbrauch zu erzielen. Trotzdem hat sich gezeigt, dass die verwendeten Batterien nur über eine begrenzte Zeit einen derartigen Drehzahlgeber mit ausreichender Spannung versorgen können. Zur Verbesserung der Situation wird beispielsweise in der DE 197 09 087 A1 vorgeschlagen, dass bei derartigen Positionsgebern, die Abtastelemente nicht gleichzeitig, sondern nacheinander aktiviert, abgefragt und deaktiviert werden, um den Bedarf an elektrischer Leistung zu reduzieren. Insgesamt gesehen führen die vorgeschlagenen Änderungen nur zu einer begrenzten Reduzierung des Stromverbrauchs, sodass ein längerer Netz unabhängiger Betrieb keinesfalls gewährleistet ist, sodass alle vorgenannten Maßnahmen den Einsatzzeitraum eines Single- oder Multiturngebers begrenzen, sofern dieser nicht mit einer permanenten Energieversorgung verbunden ist.

Die deutsche Offenlegungsschrift DE 197 09 087 A1 offenbart ein Verfahren zum Betrieb eines Positionsgebers, wobei der Positionsgeber mehrere Hall-Elemente aufweist. Zur Energieeinsparung wird vorgeschlagen die Hall-Elemente nur so lange mit der Versorgungsspannung zu verbinden, wie zur Feststellung der Position innerhalb der kleinsten Teilungsperiode benötigt wird. In der übrigen Zeit werden diese Baugruppen von der Energieversorgung getrennt.

Die EP 0 331 828 A1 offenbart einen Multiturngeber, der eine durch eine Batterie gepufferte, unterbrechungsfreie Stromversorgung aufweist.

Die EP 0 158 781 offenbart einen gattungsgemäßen Winkelgeber, der eine unterbrechungsfreie Stromversorgung aufweist. Zur Energieeinsprung wird vorgeschlagen, die von den Detektor notwendigen LED's nur für die minimale notwendige Zeit zu aktivieren, die zur Detektion der Winkelposition notwendig ist.

Die deutsche Patentschrift DE 101 11 399 C1 offenbart einen inkrementalen Messwertgeber und ein Verfahren zur Erzeugung eines absoluten Positionswertes, wobei zum Betrieb bei einem Stromausfall ein zweiter Mikroprozessor vorgesehen ist, der in Zeiten eines Stromausfalls mit geringerer Abtastfrequenz betrieben wird. Dadurch wird in Kauf genommen, dass zur Zeiten eines Stromausfalles die Winkelposition seltener bestimmt wird.

Schließlich offenbart die europäische Patentanmeldung EP 1 116 954 A2 einen elektronischen Umdrehungszähler, der seine Informationen aus REEDKontakten erhält, die bei einer Umdrehung durch einen sich drehenden Magneten geöffnet und geschlossen werden.

Der vorliegenden Erfindung liegt die Aufgabe zugrunde, einen Single- bzw. Multiturngeber aufzuzeigen, der eine Erfassung des Drehwinkels einschließlich einer Umdrehungszählung mit geringstmöglichem Aufwand ermöglicht und bei dem die Anzahl der Sensoren möglichst gering gehalten werden kann, wobei gleichzeitig eine erhebliche Reduzierung des Energieverbrauchs gewährleistet ist.

Erfindungsgemäß ist zur Lösung der Aufgabe vorgesehen, dass die Sensorteile während der periodischen Strom/Spannungsbeaufschlagung durch die Auswerteeinheit mit Strom/Spannung beaufschlagt werden und die Auswerteeinheit einen Mirkocontroller umfasst, der die Sensorteile über einen I/O-Pin nur für kurze Abtastintervalle mit Strom/Spannung versorgt, wobei der Mikrocontroller in den Pausen zwischen den Abtastungen in einem Stromspar-Mode mit verringerter Prozessortaktfrequenz und abgeschalteter Peripherie betrieben wird. Weitere vorteilhafte Ausgestaltungen der Erfindung sind den Unteransprüchen zu entnehmen.

Durch die periodische Beaufschlagung der Sensorteile mit Strom/Spannung wird der Energiebedarf erheblich reduziert, da die Sensorteile immer nur dann zum Einsatz kommen, wenn eine Messung vorzunehmen ist. Dies ist besonders vorteilhaft, da in der Regel die verfügbaren Sensoren eine sehr hohe Stromaufnahme aufweisen und somit durch das angewendete Verfahren ein Betrieb über längere Zeit mit einer im Single- oder Multiturn Geber integrierten Energiequelle ohne externe Energieversorgung sicher gestellt werden kann. Hierdurch wird die Stromaufnahme im Betrieb ohne externe Versorgungsspannung soweit minimiert, dass ein Betrieb mit Umdrehungszähler und einer Zählung vorwärts und rückwärts sowie einer Speicherung über Jahre hinweg, mit einem im Geber integrierten Akku, Batterie oder andere Energiespeicher möglich ist. Beispielsweise kann bei der Verwendung einer Lithiumzelle ein derartiger Geber über eine Laufzeit von 10 Jahren betrieben werden.

Vorzugsweise kommt die Kombination eines Permanentmagneten mit einem Magnetfeld abhängigen Sensor zur Anwendung, welche besonders raumsparend sind und beispielsweise gegenüber liegend angeordnet werden, wobei der Permanentmagnet mit der rotierenden Welle drehfest verbunden ist, während der Magnetfeld abhängige Sensor ortsfest montiert wird. Hierbei werden ein oder mehrere Sinusperioden pro mechanischer Umdrehung und einem zum ersten Sinussignal um 90° elektrisch versetztes zweites Sinussignal oder zusätzlich deren inverse Signale erzeugt, um die Winkelposition und die Anzahl der Umdrehungen festzustellen. Grundsätzlich erzeugen die Sensorelemente in Zusammenwirkung mit dem Betätigungselement, beispielsweise in Form des Permanentmagneten jeweils eine periodische Messgröße, deren Periode einem ganzzahligen Vielfachen des Winkelintervalls entspricht. Vorzugsweise weist jede Messgröße eine Periode pro vollständiger Umdrehung der Geberwelle auf. Beispielsweise kann hierfür ein magnetisches Betätigungselement mit einem Nord- und einem Südpol verwendet werden, sodass bei einer Umdrehung des Betätigungselements jedes Sensorelement eine Messgröße generiert, deren Verlauf exakt einer Sinuswelle entspricht. Hierbei ist auch denkbar, dass beispielsweise ein Permanentmagnet mit zwei, drei oder mehreren Nordpolen bzw. Südpolen verwendet wird, wobei die Periode der Messgröße demzufolge einer halben, drittel usw. Umdrehung der Geberwelle entspricht. Vorzugsweise wird die Auswerteeinheit derart ausgelegt, dass sie insbesondere die einzelnen Perioden erfassen und entsprechend zur Winkelberechnung berücksichtigen kann, wobei beispielsweise mittels einer Selektierung ggf. des Null-Durchgangs der Amplitude oder dergleichen eine oder mehrere Messgrößen realisiert werden können.

Zur Vermeidung von Störungen kann die Auswerteeinheit ggf. eine Störungsunterdrückung bzw. Kompensationseinheit aufweisen, mit deren Hilfe äußere Störungen ausgeglichen werden. Ebenso ist es möglich, die Auswerteeinheit mit einer weiteren Kompensationseinheit zu versehen, sodass durch Subtraktion zweier Messgrößen evtl. Störungen, die sich zu den Messgrößen addieren, wie beispielsweise Thermospannungen, durch Subtraktion der Messgrößen zu kompensieren. Ferner kann die Auswerteeinheit eine Kompensationseinheit in Form einer Divisionsvorrichtung enthalten, und zwar zur Division zweier Messgrößen, wodurch äußere beispielsweise fremde Magnetfeldstörungen oder dergleichen, die sich insbesondere als Störfaktor zu den Messgrößen multiplizieren, weitestgehend ausgeglichen werden können. Durch die räumliche Anordnung der Sensorteile können entsprechende störende Einflüsse durch die Kompensationseinheiten ausgeglichen werden, die in nahezu gleicher Art und Weise auf sämtliche Sensorteile einwirken, sodass auf Grund der Quotientenbildung bzw. Subtraktion diese fast vollständig eliminiert werden. Ferner kann der Auswerteeinheit ein AD-Wandler zugeordnet werden, welcher das Verhältnis zwischen einem Messsignal und einem Referenzsignal abbildet, wodurch eine aufwändige Stabilisierung des Referenzsignals vermieden wird. Durch die ermittelten Messsignale kann beispielsweise auch die Drehrichtung durch die Auswerteeinheit ermittelt werden, um die Anzahl der vollständigen Umdrehungen in beiden Drehrichtungen festzustellen, wobei entweder die Messsignale zur Auswertung heran gezogen werden oder aber in einfachster Konstruktion ein Schaltelement, beispielsweise ein Reedkontakt, verwendet wird, welcher in Abhängigkeit des drehbaren Betätigungselements geöffnet bzw. geschlossen wird, sodass die Anzahl der Umdrehungen mittels eines Zählers festgestellt werden kann.

Der wesentliche Punkt der vorliegenden Erfindung besteht jedoch darin, dass die verwendeten Sensorteile und insbesondere weitere evtl. eingesetzte Schaltelemente nur periodisch für die Zeit der Messung mit Strom/Spannung beaufschlagt werden. Hierzu wird in der Regel ein Mikrocontroller verwendet, der in der Auswerteeinheit enthalten ist und die Sensorteile über einen I/O-Pin nur für kurze Abtastintervalle mit Strom/Spannung versorgt. In besonders vorteilhafter Ausgestaltung schlägt das Verfahren im Weiteren vor, dass der Mikrocontroller während der Pausen zwischen den Abtastungen in einem Stromsparmode mit verringerter Prozessortaktfrequenz und abgeschalteter Peripherie betrieben wird, sodass der Energieverbrauch weiterhin abgesenkt werden kann. Der Mikrocontroller kann beispielsweise selbst das Timing der Abtastrate und des Abtastintervalls bestimmen oder aber es besteht die Möglichkeit durch einen Timer die Abtastrate und das Abtastintervall vorzugeben. Hierbei wird die Abtastrate so gewählt, dass eine sichere Erkennung der Positionsänderung über einen Quadranten einer Sinusperiode des Sensorsignals erfolgen kann. Anhand der erzielten Messsignale kann der Mikrocontroller die Drehrichtung und Umdrehungszahl erfassen und speichern, sodass sämtliche relevanten Daten zur Positionsbestimmung jederzeit abrufbar sind bzw. über eine angeschlossene Signalschnittstelle einer weiteren entfernt liegenden Erfassungseinrichtung zugeleitet werden können.

In weiterer Ausgestaltung des Verfahrens ist vorgesehen, dass der Mikrocontroller selbstständig eine Überwachung einer externen anliegenden Betriebsspannung über einen integrierten oder externen Komparator oder einen I/O-Pin vornimmt und in Abhängigkeit einer anliegenden Betriebsspannung selbstständig zwischen einem Stromspar-Mode oder Normalbetrieb umschaltet. Hierbei ist vorgesehen, dass das Integral zur Stromaufnahme der Sensorteile und des auswertenden Mikrocontrollers einen Betrieb ohne externe StromSpannungsversorgung über mehrere Jahre hinweg gewährleistet, wobei für eine Pufferung im Gebergehäuse eine Batterie, ein Akku oder andere Energiequellen integriert sind, die in Abwesenheit einer externen Versorgungsspannung auf Grund des aufgezeigten Verfahrens nur mit einer geringen Energiebelastung betrieben wird.

Das erfindungsgemäße Verfahren geht somit von einem Zusammenwirken der Auswerteeinheit, der Sensorteile und weiteren zugehörigen Schaltungskomponenten aus, bei der die Auswerteeinheit durch einen Timer von einem Stromspar-Mode in einen Aktiv-Mode mit hoher Prozessortaktfrequenz und zugeschalteter Peripherie überführt wird, wobei der Timer die Abtastrate und das Abtastintervall bestimmt, und nach Aktivierung der Auswerteeinheit die Sensorteile mit Energie beaufschlagt werden, eine Messung mit Speicherung der Messwerte erfolgt und anschließend die Sensorteile von der Energiequelle getrennt werden und eine Messsignaläuswertung und Positionsberechnung sowie Abspeicherung der ermittelten Position erfolgt, danach die Auswerteeinheit in Abhängigkeit einer fehlenden externen Energieversorgung in den Stromspar-Mode überführt wird, bis der Timer einen neuen Messzyklus einleitet.

Zur Messung und Bestimmung der absoluten Position einer Geberwelle wird ferner eine Einrichtung vorgeschlagen, bestehend aus Sensorteilen, einer Geberelektronik mit Mikrokontroller, einer Energiespeichereinheit und einem Schnittstellentreiber, bei der die strom- und spannungsabhängigen Komponenten, insbesondere Sensorteile periodisch für die Zeit der Messung mit Strom/Spannung beaufschlagbar sind und/oder die Geberelektronik in einem Energiespar-Modus überführbar ist. Durch die aufgezeigten Maßnahmen wird in vorteilhafter Weise der Energieverbrauch auf ein absolutes Minimum reduziert, sodass die elektronische Schaltung über mehrere Jahre hinweg mit ein und derselben Energiequelle betrieben werden kann. Hierzu werden beispielsweise Sensorteile verwendet, die aus zumindest einem Permanentmagneten und einem Magnetfeldsensor, vorzugsweise integrierten Halbleitersubstrat, in dem mehrere kreuzförmig angeordnete Magnetfeld empfindliche Sensoren eingebettet sind, verwendet. Diese Magnetfeldsensoren werden in vorteilhafter Weise bereits in einem Mikrochip integriert, sodass die Auswerteeinheit, die Magnetfeldsensoren und weitere elektronische Komponenten platzsparend angeordnet sind und eventuelle Störsignale besser kompensiert werden können. Zur Verbesserung der Auflösung kann ggf. die Anzahl der Pole des Permanentmagneten, beispielsweise in Form eines Polrades, auf der Geberwelle erhöht werden und im Bedarfsfall kann durch die Verwendung von Reedkontakten, die sich unter Einwirkung der vorhandenen Permanentmagnete öffnen und schließen ein einfacher Zählmechanismus vorgesehen werden, der über einen Zähler die Anzahl der Umdrehungen feststellt, sofern nicht eine Auswertung der Messsignale zur Ermittlung der Umdrehungen vorgezogen wird. Ebenso besteht die Möglichkeit, dass die Sensorteile anstatt eines Magneten aus einer Kodierscheibe und einer optischen Abtastvorrichtung, beispielsweise LED, Laserdiode, Reflexionslichtschranke bestehen, wenn der Einsatz von Permanentmagneten nicht gewünscht wird.

Zusammenfassend kann somit festgestellt werden, dass das erfindungsgemäße Verfahren und die zur Anwendung des Verfahrens vorgesehene Einrichtung eine erhebliche Energieeinsparung bewirkt und somit die Multiturngeber vorzugsweise in einem Bereich eingesetzt werden können, in dem eine Energieversorgung auf Grund der vorhandenen Bauweise sehr schwierig ist bzw. die Zugänglichkeit erschwert ist. Besonders geeignet sind derartige Multiturngeber zur Bestimmung der Rotorlage bei Werkzeugmaschinen oder Robotern, die über einen längeren Betriebszyklus ununterbrochen laufen und demzufolge einerseits sehr beweglich sein müssen und andererseits von einer externen Energiequelle möglichst abgekoppelt sein sollten. Durch die Aufschaltung einer externen Energiequelle können jedoch zu jedem beliebigen Zeitraum die ermittelten Daten über vorhandene Treiberbausteine, die erst zu diesem Zweck mit Spannung versorgt werden, an entfernte Kontrollstationen übermittelt oder energiesparende Sendeeinrichtungen mit niedriger Sendeleistung zur Übermittlung der Daten eingesetzt werden, sofern keine störenden Einflüsse vorhanden sind.

Die Erfindung wird im Weiteren anhand einer Figur, eines Blockschaltbilds und eines Flussdiagramms nochmals erläutert.

Es zeigt
- Figur 1: eine schematische, geschnittene Darstellung eines erfindungsgemäßen Multiturngebers,
- Figur 2: ein Blockschaltbild der Geberelektronik und
- Figur 3: ein Flussdiagramm des Verfahrensablaufs.

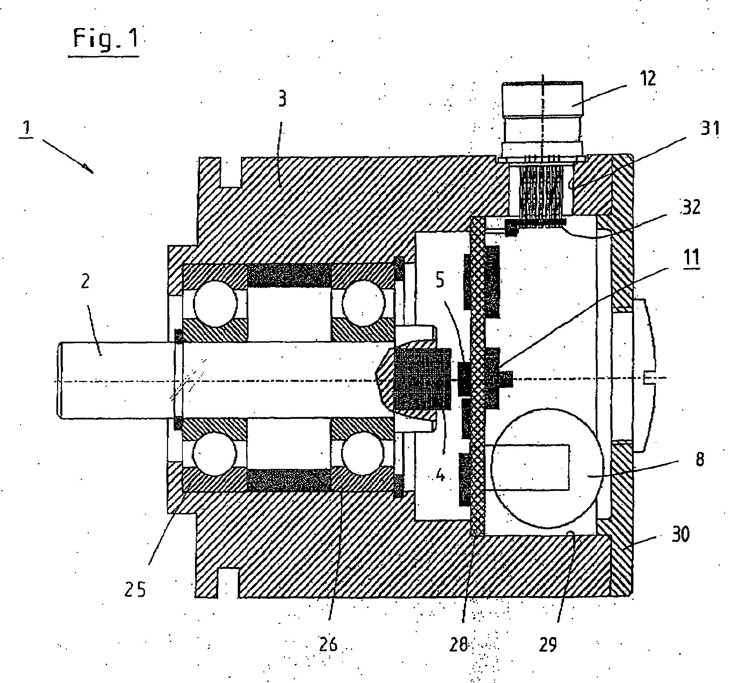

Figur 1 zeigt in einer schematischen, geschnittenen Ansicht einen erfindungsgemäßen Multiturngeber 1, der aus einem :Geberflansch 3 und einer in dem Geberflansch 3 aufgenommenen Welle 2 besteht, die über Lagerelemente 25, 26 drehbar abgestützt ist. An der Stirnfläche 27 der Welle 2 ist ein Permanentmagnet 4 als Maßverkörperung drehfest befestigt, der unmittelbar mit einem Magnetfeld abhängigen Sensor 5 zusammen wirkt. Der Magnetfeld abhängige Sensor 5 ist im gezeigten Ausführungsbeispiel auf einer Leiterplatte 28 befestigt, die im Weiteren die Komponenten der Auswerteeinheit bzw. Geberelektronik 11 aufnimmt. Zu diesem Zweck weist der Geberflansch 3 eine abgestufte Ausnehmung 29 auf, die durch einen Deckel 30 verschließbar ist. Des Weiteren befindet sich in der Außenwand ein Durchbruch 31, der zur Aufnahme eines Schnittstellenanschlusses 12 dient. Im gezeigten Ausführungsbeispiel ist die Leiterplatte 28 beidseitig mit elektronischen Komponenten bestückt, beispielsweise dem Magnetfeld abhängigen Sensor 5, einer Energiespeichereinheit 8 sowie weiteren Elementen, die beispielsweise aus dem Blockschaltdiagramm ersichtlich sind. Über eine Kontaktleiste 32 erfolgt ein Anschluss der Signalschnittstelle 12, sodass die ermittelten Messwerte einer entfernt liegenden Einrichtung zugeführt werden können.

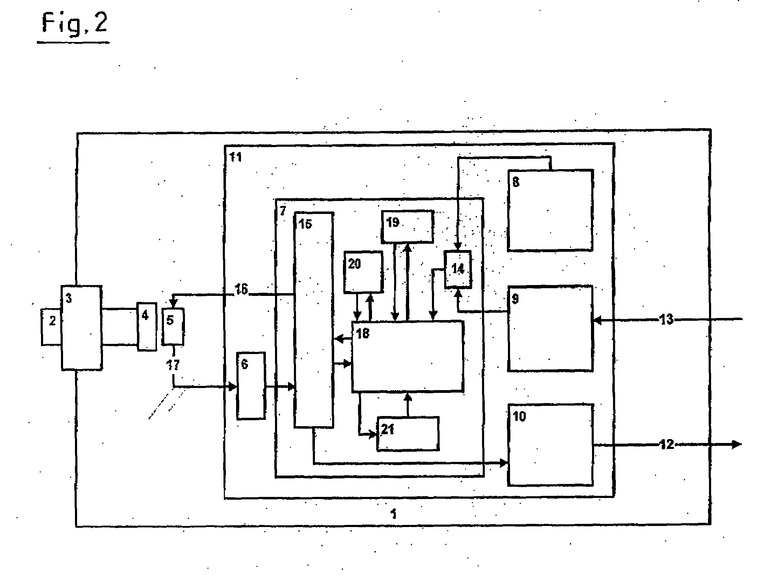

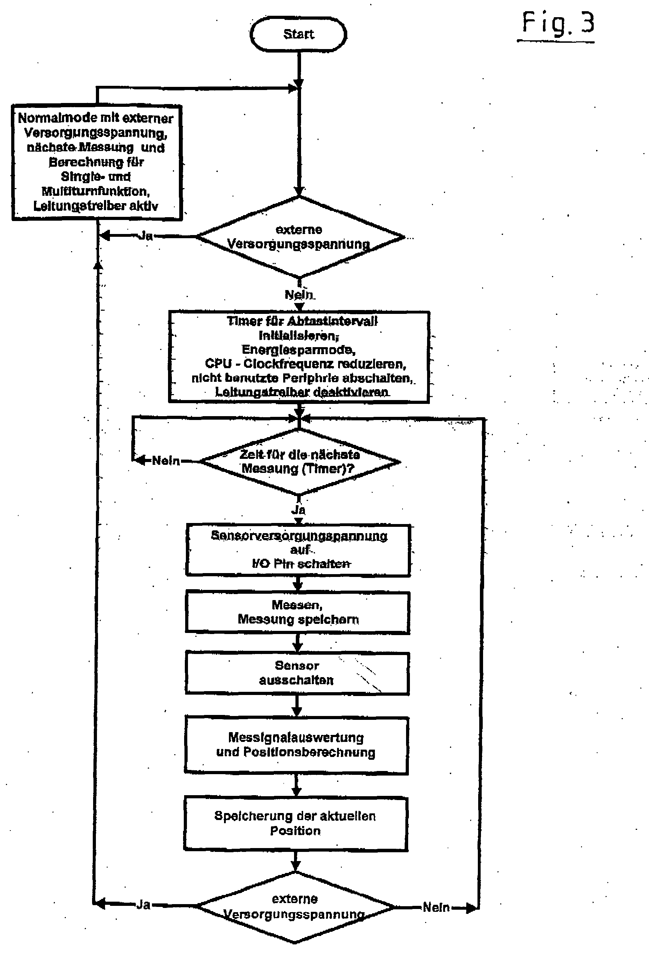

Figur 2 zeigt ein Blockschaltbild mit dem aus Figur 3 bekannten Geberflansch 3, der rotierend gelagerten Welle 2 sowie dem kopfseitig befestigten Permanentmagneten 4. Gegenüber dem Permanentmagnet 4 ist der Magnetfeld abhängige Sensor 5 angeordnet, der seine Versorgungsspannung über einen I/O-Port erhält. Die ermittelten Messsignale 17 werden einer Signalanpassung 6 zugeführt, von der die Signale auf den A/D-Wandler 15 weitergeleitet werden. Der A/D-Wandler 15 ist Bestandteil eines Mikrocontrollers 7, der im Weiteren eine CPU 18, einen Timer 19, einen Speicher 20, eine Clock 21 und einen Komparator 14 umfasst. Die CPU 18 wird zur Auswertung der ermittelten und aufgenommenen Signale durch den A/D-Wandler 15 eingesetzt und hierbei von der Clockeinheit 21 getaktet. Die ermittelten Messwerte werden in dem Speicher 20 zur weiteren und späteren Verarbeitung abgelegt, wobei die gesamte Mikrocontrollereinheit bzw. Auswerteeinheit 7 wahlweise über die CPU 18 oder den Timer 19 gesteuert wird. Zusätzlich wird über einen Komparator 14 festgestellt, ob eine externe Spannungsversorgung anliegt oder die Energieversorgung ausschließlich von der Energiespeichereinheit 8 erfolgt. Zu diesem Zweck befindet sich neben dem Mikrocontroller 7 in der Geberelektronik 11 eine Energiespeichereinheit 8, ein Netzteil 9 sowie ein Schnittstelltreiber 10, der die Signale über die Signalschnittstelle 12 weiter leitet.

Figur 3 zeigt ein Flussdiagramm, welches den Ablauf des Messverfahrens veranschaulicht. Nach einem Start der Geberelektronik 11 wird zunächst festgestellt, ob eine externe Versorgungsspannung anliegt und für den Fall einer vorhandenen externen Versorgungsspanriung wird der Normal-Mode mit externer Versorgungsspannung, Messungsdurchführung und Berechnung der Single- und Multiturnfunktionen vorgenommen. Dieser Zyklus wiederholt sich solange bis festgestellt wird, dass die externe Versorgungsspannung nicht mehr vorhanden ist, dann generiert der Timer ein Abtastintervall und initialisiert den Mikrocontroller 7, sodass dieser in einen Energiespar-Modus überführt wird. Im Energiespar-Modus wird die CPU Clockfrequenz reduziert und die nicht benutzte Peripherie abgeschaltet und die Leitungstreiber deaktiviert bis zum Durchlaufen eines neuen Messzyklusses. Der Messzyklus wird durch den Timer vorgegeben und hierzu erfolgt eine Abfrage, ob der nächste Messzyklus durchgeführt werden soll oder nicht. Für den Fall eines neuen Messzyklusses werden über einen I/O-Pin des Mikrocontrollers 7 die Sensorteile mit Spannung versorgt, die Messung durchgeführt und das Messergebnis gespeichert. Anschließend werden die Sensorteile ausgeschaltet und eine Messsignalauswertung und Positionsberechnung durch den Mikrocontroller 7 in Zusammenarbeit mit der CPU 18 durchgeführt, wobei die ermittelten Messsignale über den I/O-Port und A/D-Wandler 15 der CPU 18 zugeführt und die ermittelten Positionsberechnungen dem I/O Port zurückgeführt, sodass dieser die Informationen über den Schnittstellengeber 10 und die Signalschnittstelle 12 weiterleiten kann. Nach einer Speicherung der aktuellen Position wird wiederum geprüft, ob eine externe Versorgungsspannung anliegt und entweder die Geberelektronik 11 in den Normal-Mode überführt oder der Energiespar-Mode beibehalten und durch den Timer 19 der Messzyklus festgelegt. Anstelle eines A/D-Wandlers zur Positionsbestimmung kann bei der Verwendung eines digitalen Eingangs auf diesen verzichtet werden und es wird lediglich ein I/O-Port benötigt.

### Bezugszeichenliste

- 1: Multiturngeber
- 2: Welle/Geberwelle
- 3: Geberflansch
- 4: Permanentmagnet
- 5: Magnetfeld abhängiger Sensor
- 6: Signalanpassung
- 7: Mikrocontroller
- 8: Energiespeicherelement
- 9: Netzteil
- 10: Schnittstellentreiber
- 11: Geberelektronik/Auswerteeinheit
- 12: Signalschnittstelle
- 13: Versorgungsspannung
- 14: Komparator
- 15: I/O-Port und A/D-Wandler
- 16: Sensorstromversorgung
- 17: Sensorsignale
- 18: CPU
- 19: Timer
- 20: Speicher
- 21: Clock

- 25: Lagerelement
- 26: Lagerelement
- 27: Stirnfläche
- 28: Leiterplatte
- 29: Ausnehmung
- 30: Deckel
- 31: Durchbruch
- 32: Kontaktleiste

## Patentansprüche

1. Verfahren zur Messung und Bestimmung der absoluten Position einer Geberwelle (2) durch eine Auswerteeinheit (11) zur Erfassung und Auswertung der Position und der Anzahl der vollständig durchlaufenden Umdrehungen, mit einem drehfest gehaltenen ersten Sensorteil (4, 5) und einem an der Geberwelle (2) angeordneten, mit diesem rotierenden, zweiten Sensorteil (4, 5), wobei zumindest ein Sensorteil von einer Energiequelle versorgt wird und wobei die Sensorteile (4, 5) nur periodisch für die Zeit der Messung mit Strom/Spannung beaufschlagt werden,
**dadurch gekennzeichnet,**
**dass** die Sensorteile während der periodischen Strom/Spannungsbeaufschlagung durch die Auswerteeinheit (11) mit Strom/Spannung beaufschlagt werden und die Auswerteeinheit (11) einen Mirkocontroller (7) umfasst, der die Sensorteile (4, 5) über einen I/O-Pin nur für kurze Abtastintervalle mit Strom/Spannung versorgt, wobei der Mikrocontroller (7) in den Pausen zwischen den Abtastungen in einem Stromspar-Mode mit verringerter Prozessortaktfrequenz und abgeschalteter Peripherie betrieben wird.

2. Verfahren nach Anspruch 1,
**dadurch gekennzeichnet,**
**dass** der Mikrocontroller (7) das Timing für Abtastrate und Abtastintervall selber generiert oder dass durch einen Timer (13) die Abtastrate und das Abtastintervall vorgegeben wird.

3. Verfahren nach Anspruch 1 oder 2,
**dadurch gekennzeichnet,**
**dass** die Abtastrate so gewählt wird, das eine sichere Erkennung der Positionsänderung über einen Quadranten einer Sinusperiode des Sensorsignals erfolgt.

4. Verfahren nach Anspruch 1, 2 oder 3,
**dadurch gekennzeichnet,**
**dass** der Mikrocontroller (7) die Drehrichtung und Umdrehungszahl erfasst und speichert.

5. Verfahren nach einem oder mehreren der Ansprüche 1 bis 4,
**dadurch gekennzeichnet,**
**dass** der Mikrocontroller (7) selbstständig eine Überwachung einer extern anliegenden Betriebsspannung über einen integrierten oder externen Komparator (14) oder einen I/O-Pin vornimmt.

6. Verfahren nach einem oder mehreren der Ansprüche 1 bis 5,
**dadurch gekennzeichnet,**
**dass** der Mikrocontroller (7) zwischen Normalbetrieb, mit externer Strom/Spannungsversorgung, und Stromspar-Mode selbsttätig umschaltet.

7. Verfahren nach einem oder mehreren der Ansprüche 1 bis 6,
**dadurch gekennzeichnet,**
**dass** das Integral der Stromaufnahme der Sensorteile (4,5) und des auswertenden Mikrocontrollers (7) einen Betrieb ohne externe Strom/Spannungsversorgung über mehrere Jahre gewährleistet.

8. Verfahren nach einem oder mehreren der Ansprüche 1 bis 7,
**dadurch gekennzeichnet,**
**dass** die Sensorteile (4,5) und Auswerteeinheit (11) ohne externe Strom/Spannungsversorgung durch eine im Gebergehäuse integrierte Batterie, Akku oder andere Energiequellen betrieben werden.

9. Verfahren nach einem oder mehreren der Ansprüche 1 bis 8,
**dadurch gekennzeichnet,**
**dass** die Auswerteeinheit (11) durch einen Timer (19) von einem Stromspar-Mode in einen Aktiv-Mode mit hoher Prozessortaktfrequenz und zugeschalteter Peripherieeinheit überführt wird, wobei der Timer (19) die Abtastrate und das Abtastintervall bestimmt, und nach Aktivierung der Auswerteeinheit (11) die Sensorteile (4,5) mit Energie beaufschlagt werden, eine Messung mit Speicherung der Messwerte erfolgt und anschließend die Sensorteile (4,5) von der Energiequelle getrennt werden und eine Messsignalauswertung und Positionsberechnung sowie Speicherung der ermittelten Position erfolgt, danach die Auswerteeinheit (11) in Abhängigkeit einer fehlenden externen Energieversorgung in den Stromspar-Mode überführt wird, bis der Timer (19) einen neuen Testzyklus einleitet.

10. Einrichtung zur Messung und Bestimmung der absoluten Position einer Geberwelle (2) zur Durchführung des Verfahrens nach einem oder mehreren der Ansprüche 1 bis 9, bestehend aus Sensorteilen (4,5), einer Geberelektronik (11) mit Mikrocontroller (7), einer Energiespeichereinheit (8) und einem Schnittstellentreiber (10), in welcher die strom- und spannungsabhängigen Komponenten, wie Sensorteile (4, 5), periodisch für die Zeit der Messung mit Strom/Spannung beaufschlagbar sind,
**dadurch gekennzeichnet,**
**dass** die Geberelektronik (11) in einen Energiespar-Modus überführbar ist, wobei der Mikrocontroller die Sensorteile über einen I/O-Pin nur für kurze Abtastintervalle mit Strom/Spannung versorgt, und wobei der Mikrocontroller in den Pausen zwischen den Abtastungen in einen Stromspar-Mode mit verringerter Prozessortaktfrequenz und abgeschalteter Peripherie überführbar ist.

11. Einrichtung nach Anspruch 10,
**dadurch gekennzeichnet,**
**dass** die Sensorteile aus zumindest einem Permanentmagneten (4) und einem Magnetfeldsensor (5), vorzugsweise integrierten Halbleitersubstrat, in dem mehrere kreuzförmig angeordnete magnetfeldempfindliche Sensoren eingebettet sind, besteht, oder dass Hall-Sensoren verwendet werden.

12. Einrichtung nach Anspruch 11,
**dadurch gekennzeichnet,**
**dass** mehrere, vorzugsweise eine gerade Anzahl von Permanentmagnetpolen verwendet wird.

13. Einrichtung nach einem oder mehreren der Ansprüche 10 - 12,
**dadurch gekennzeichnet,**
**dass** die Sensorteile (4,5) aus zumindest einer oder mehreren Kodierscheiben und einer optischen oder magnetischen Abtastvorrichtung, beispielsweise LED, Photodiode, Laserdiode, Reflexionslichtschranke oder einem magnetabhängigen Sensorelement bestehen.

## Claims

1. Method for measuring and determining the absolute position of a transducer shaft (2) by an evaluation unit (11) for detecting and evaluating the position and the number of rotations completely passed through, with a stationarily held first sensor part (4, 5) and a second sensor part (4, 5) arranged at the transducer shaft (2) and rotating along with it, wherein at least one sensor part is fed by a source of energy, and wherein the sensor parts (4, 5) are only periodically supplied with current/voltage during the time of measurement,
**characterized in that**
the sensor parts are supplied with current/voltage by the evaluation unit (11) during the periodical current/voltage supply, and the evaluation unit (11) comprises a microcontroller (7) supplying the sensor parts (4, 5) via an I/O pin only during short sampling intervals, wherein the microcontroller (7) is operated with a sleep mode with reduced processor clock rate and switched-off periphery in the pauses between the samplings.

2. Method according to claim 1,
**characterized in that**
the microcontroller (7) itself generates the timing for sampling rate and sampling interval, or a timer (13) predetermines the sampling rate and the sampling interval.

3. Method according to claim 1 or 2,
**characterized in that**
the sampling rate is selected such that a secure recognition of the change of position is made via a quadrant of a sinus period of the sensor signal.

4. Method according to claim 1, 2 or 3,
**characterized in that**
the microcontroller (7) detects and stores the sense of rotation and number of revolutions.

5. Method according to one or more of claims 1 to 4,
**characterized in that**
the microcontroller (7) independently monitors an externally applied operating voltage via an integrated or external comparator (14) or an I/O pin.

6. Method according to one or more of claims 1 to 5,
**characterized in that**
the microcontroller (7) automatically switches between normal operation, with external current/voltage supply, and sleep mode.

7. Method according to one or more of claims 1 to 6,
**characterized in that**
the integral of the current consumption of the sensor parts (4, 5) and the evaluating microcontroller (7) ensures an operation without external current/voltage supply over several years.

8. Method according to one or more of claims 1 to 7,
**characterized in that**
the sensor parts (4, 5) and the evaluation unit (11) are operated by a battery, accumulator or other sources of energy integrated in the transducer housing without any external current/voltage supply.

9. Method according to one or more of claims 1 to 8,
**characterized in that**
the evaluation unit (11) is transferred from a sleep mode to an active mode with a high processor clock rate and connected periphery unit by a timer (19), wherein the timer (19) determines the sampling rate and the sampling interval, and after the activation of the evaluation unit (11), the sensor parts (4, 5) are supplied with energy, a measurement with storage of the measured values is performed, and subsequently the sensor parts (4, 5) are disconnected from the source of energy and a measured signal evaluation and position calculation as well as storage of the detected position are performed, then the evaluation unit (11) is transferred to the sleep mode in response to a missing external energy supply until the timer (19) initiates a new test cycle.

10. Device for measuring and determining the absolute position of a transducer shaft (2) for executing the method according to one or more of the claims 1 to 9, consisting of sensor parts (4, 5), transducer electronics (11) with microcontroller (7), an energy storage unit (8) and an interface driver (10) in which the current- and voltage-depending components, such as sensor parts (4, 5) can be periodically supplied with current/voltage for the time of the measurement,
**characterized in that**
the transducer electronics (11) can be transferred to an energy-saving mode, wherein the microcontroller supplies the sensor parts with current/voltage via an I/O pin only during short sampling intervals, and wherein the microcontroller can be transferred to a sleep mode with reduced processor clock rate and switched-off periphery in the pauses between the samplings.

11. Device according to claim 10,
**characterized in that**
the sensor parts consist of at least one permanent magnet (4) and a magnetic-field sensor (5), preferably an integrated semi-conductor substrate, in which several crosswise arranged sensors that are sensitive to magnetic fields are embedded, or that Hall sensors are used.

12. Device according to claim 11,
**characterized in that**
several, preferably an even number of permanent magnetic poles are used.

13. Device according to one or more of claims 10 - 12,
**characterized in that**
the sensor parts (4, 5) consist of at least one or several shaft position encoders and an optical or magnetic sampling device, for example LED, photodiode, laser diode, reflection light barrier, or a magnet-depending sensor element.

## Revendications

1. Procédé pour mesurer et définir la position absolue d'un arbre de capteur (2) par l'intermédiaire d'une unité de traitement (11) destinée à saisir et traiter la position et la quantité des tours entièrement réalisés, avec un premier élément capteur non rotatif (4, 5) et un second élément capteur (4, 5) disposé sur l'arbre de capteur (2) et en rotation avec ledit arbre de capteur (4, 5), un élément capteur au moins étant alimenté par une source d'énergie et les éléments capteurs (4, 5) n'étant alimentés en courant/tension que périodiquement durant le temps de la mesure.
**caractérisé par le fait que** les éléments capteurs sont alimentés en courant/tension pendant l'alimentation périodique en courant/tension par l'intermédiaire de l'unité de traitement (11) et que l'unité de traitement (11) comprend un microcontrôleur (7) alimentant en courant/tension les éléments capteurs (4, 5) via une broche E/S seulement pour de courts intervalles d'échantillonnage, le microcontrôleur (7) fonctionnant pendant les pauses entre les échantillonnages dans un mode d'économie d'énergie avec une fréquence de fonctionnement du processeur réduite, les périphériques étant hors tension.

2. Procédé selon la revendication 1,
**caractérisé par le fait que** le microcontrôleur (7) génère lui-même la synchronisation de la cadence et de l'intervalle d'échantillonnage ou que la cadence et l'intervalle d'échantillonnage est définie par l'intermédiaire d'un temporisateur (13).

3. Procédé selon la revendication 1 ou 2,
**caractérisé par le fait que** la cadence d'échantillonnage est choisie de telle sorte qu'une reconnaissance sûre de la modification de position s'effectue par l'intermédiaire d'un quadrant d'une période sinusoïdale du signal capteur.

4. Procédé selon la revendication 1, 2 ou 3,
**caractérisé par le fait que** le microcontrôleur (7) saisit et enregistre le sens de rotation et le nombre de tours.

5. Procédé selon une ou plusieurs des revendications 1 à 4,
**caractérisé par le fait que** le microcontrôleur (7) procède de manière autonome à une surveillance d'une tension externe de fonctionnement via un comparateur intégré ou externe (14) ou une broche E/S.

6. Procédé selon une ou plusieurs des revendications 1 à 5,
**caractérisé par le fait que** le microcontrôleur (7) commute automatiquement entre fonctionnement normal, avec alimentation en courant/tension externe, et mode d'économie d'énergie.

7. Procédé selon une ou plusieurs des revendications 1 à 6,
**caractérisé par le fait que** l'intégrale de l'intensité de courant consommée par les éléments capteurs (4,5) et par le microcontrôleur de traitement (7) garantit un fonctionnement sans alimentation en courant/tension externe pendant plusieurs années.

8. Procédé selon une ou plusieurs des revendications 1 à 7,
**caractérisé par le fait que** les éléments capteurs (4,5) et l'unité de traitement (11) fonctionnent sans alimentation en courant/tension externe par l'intermédiaire d'une batterie, d'un accumulateur intégrés dans le boîtier capteur ou d'autres sources d'énergie.

9. Procédé selon une ou plusieurs des revendications 1 à 8,
**caractérisé par le fait que** l'unité de traitement (11) passe par l'intermédiaire d'un temporisateur (19) d'un mode d'économie d'énergie à un mode actif avec une fréquence de fonctionnement du processeur élevée et l'unité périphérique sous tension,
le temporisateur (19) déterminant la cadence et l'intervalle d'échantillonnage, et après activation de l'unité de traitement (11) les éléments capteurs (4,5) étant alimentés en énergie, une mesure avec enregistrement des valeurs mesurées étant effectuée et ensuite les éléments capteurs (4,5) étant séparés de la source d'énergie et un traitement des signaux de mesure et un calcul de la position ainsi qu'un enregistrement de la position déterminée étant effectués, puis l'unité de traitement (11) passant, en réponse à une absence d'alimentation en énergie externe, en mode d'économie d'énergie, jusqu'à ce que le temporisateur (19) amorce une nouveau cycle de test.

10. Dispositif pour mesurer et définir la position absolue d'un arbre de capteur (2) destiné à effectuer le procédé selon une ou plusieurs des revendications 1 à 9, comportant des éléments capteurs (4,5), une électronique de capteur (11) avec microcontrôleur (7), une unité de stockage d'énergie (8) et un pilote d'interface (10), dans lequel les composants dépendant du courant et de la tension, comme les éléments capteurs (4, 5), peuvent être alimentés périodiquement en courant/tension pour la durée de mesure,
**caractérisé par le fait que** l'électronique de capteur (11) peut passer en mode d'économie d'énergie, le microcontrôleur alimentant en courant/tension les éléments capteurs via une broche E/S seulement pour de courts intervalles d'échantillonnage,
et le microcontrôleur (7) pouvant passer pendant les pauses entre les échantillonnage dans un mode d'économie d'énergie avec une fréquence de fonctionnement du processeur réduite, les périphériques étant hors tension.

11. Dispositif selon la revendication 10,
**caractérisé par le fait que** les éléments capteurs sont composés d'au moins un aimant permanent (4) et d'un capteur de champ magnétique (5), préférentiellement d'un substrat semi-conducteur intégré, dans lequel sont insérés plusieurs capteurs de champ magnétique disposés en forme de croix, ou que des capteurs à effet Hall sont utilisés.

12. Dispositif selon la revendication 11,
**caractérisé par le fait que** plusieurs, préférentiellement un nombre pair de pôles d'aimants permanents, sont utilisés.

13. Procédé selon une ou plusieurs des revendications 10 à 12,
**caractérisé par le fait que** les éléments capteurs (4,5) sont composés d'au moins un ou plusieurs disques de codage et d'un dispositif de détection optique ou magnétique, par exemple une LED, une photodiode, une diode laser, une barrière lumineuse à réflexion ou un élément capteur magnétique.
